# DEMANDE DE BREVET EUROPEEN

(11) **EP 1 104 014 A1**
(43) Date de publication de la demande: **30.05.2001**
(21) Numéro de dépôt: 00403167.0
(22) Date de dépôt: 14.11.2000
(51) Int. Cl.: H01L 21/331, H01L 29/732, H01L 29/08

(54) **Transistor vertical à faible bruit basse fréquence et gain en courant élevé, et procédé de fabrication correspondant**

(30) Priorité: 23.11.1999 FR 9914746
(71) Demandeur: STMicroelectronics SA, 94250 Gentilly Cedex (FR); FRANCE TELECOM, 75015 Paris (FR)
(72) Inventeur: Marty, Michel, 38760 St. Paul de Varces (FR); Dutartre, Didier, 38000 Grenoble (FR); Chantre, Alain, 38180 Seyssins (FR); Jouan, Sebastien, 38000 Grenoble (FR); Llinares, Pierre, 38920 Crolles (FR)
(74) Mandataire: Casalonga, Axel

(57) **Abrégé**

Le transistor bipolaire vertical comprend un collecteur intrinsèque (4) disposé sur une couche de collecteur extrinsèque (2) enterrée dans un substrat semiconducteur, une région d'isolement latéral (5) entourant la partie supérieure du collecteur intrinsèque, un puits de collecteur extrinsèque déporté (60), une base (8) comprenant une région semiconductrice située au-dessus du collecteur intrinsèque et de la région d'isolement latéral et comportant au moins une couche de silicium, et un émetteur bipartite dopé (11), entouré par la base, comportant une première partie (110) formée de silicium monocristallin et directement en contact avec la surface supérieure de ladite région semiconductrice dans une fenêtre prédéterminée (800) de ladite surface supérieure située au-dessus du collecteur intrinsèque, et une deuxième partie (111) formée de silicium polycristallin, les deux parties de l'émetteur étant séparées par une couche séparatrice d'oxyde (112) située à distance de la jonction émetteur-base du transistor.

## Description

L'invention concerne les transistors bipolaires verticaux, notamment ceux destinés à s'intégrer dans les technologies haute fréquence et à très haut degré d'intégration (technologie VLSI : "Very Large Scale Integration" en langue anglaise), et en particulier les caractéristiques et la réalisation des émetteurs de ces transistors.

Dans les technologies bipolaires à émetteur polysilicium, l'émetteur résulte d'un dépôt de polysilicium qui peut être effectué dans un four classique suivi d'un dopage. En variante, l'émetteur peut être dopé in situ dans un réacteur de dépôt chimique en phase vapeur (dépôt CVD: "Chemical Vapor Deposition").

Dans les deux cas, une couche d'oxyde est présente à l'interface émetteur/base. Cette couche limite le courant de trous dans la base (les électrons injectés continuent à passer par effet tunnel) ce qui contribue à obtenir un gain en courant (Ic/Ib) suffisant.

Cependant, ces transistors à émetteur polysilicium présentent du bruit à basse fréquence ce qui se traduit par des fluctuations basse fréquence du courant du transistor. Ceci est d'autant plus gênant pour des circuits radiofréquence incorporant de tels transistors et à l'aide desquels on souhaite séparer deux porteuses proches, ou encore pour des oscillateurs.

Un but de l'invention est de proposer un transistor bipolaire vertical ayant un bruit basse fréquence réduit tout en présentant des paramètres statiques acceptables, et notamment un gain correct en courant.

L'invention propose donc un procédé de fabrication d'un transistor bipolaire vertical comprenant:
- une étape de réalisation d'un collecteur intrinsèque, par exemple par épitaxie ou implantation, sur une couche de collecteur extrinsèque enterrée dans un substrat semiconducteur,
- une étape de réalisation d'une région d'isolement latéral entourant la partie supérieure du collecteur intrinsèque, et d'un puits de collecteur extrinsèque déporté,
- une étape de réalisation d'une base, par exemple une base totalement silicium ou de préférence à hétérojonction SiGe (Silicium-Germanium), située au-dessus du collecteur intrinsèque et de la région d'isolement latéral et comportant une épitaxie non sélective d'une région semiconductrice comportant au moins une couche de silicium (dans le cas d'une base totalement silicium),
- une étape de réalisation d'un émetteur bipartite dopé in situ comportant une première sous-étape de réalisation d'une première partie de l'émetteur formée de silicium monocristallin et directement en contact avec une partie ("fenêtre émetteur") de la surface supérieure de ladite région semiconductrice située au-dessus du collecteur intrinsèque, et une deuxième sous-étape de réalisation d'une deuxième partie de l'émetteur formée de silicium polycristallin et séparée de la première partie de silicium monocristallin par une couche séparatrice d'oxyde.

En d'autres termes, l'émetteur du transistor selon l'invention est constitué de deux parties. Une première partie, c'est-à-dire la partie basse, qui est proche de la jonction émetteur base est épitaxiée, ce qui permet d'éloigner l'interface d'oxyde de la jonction, cette interface d'oxyde étant une source de bruit basse fréquence. Puis, après avoir réalisé un interface d'oxyde sur la partie épitaxiée monocristalline, l'émetteur est réalisé en polysilicium dopé in situ, ce qui permet de conserver des caractéristiques statiques élevées et notamment un gain en courant élevé.

Selon un mode de mise en oeuvre de l'invention compatible avec une base SiGe, l'étape de réalisation de la base comporte une épitaxie non sélective d'un empilement de couche formant ladite région semiconductrice et comportant outre ladite couche de silicium, au moins une couche de silicium germanium, par exemple une couche de SiGe encapsulée par deux couches de silicium ou bien une couche de SiGe surmontant une couche de silicium. Par ailleurs, la première sous-étape de réalisation de l'émetteur comporte une épitaxie sur une fenêtre prédéterminée ("fenêtre émetteur") de la surface dudit empilement située au-dessus du collecteur intrinsèque de façon à obtenir au-dessus de ladite fenêtre ladite première partie de la région d'émetteur formée de silicium monocristallin et directement en contact avec la couche supérieure dudit empilement.

La deuxième sous-étape comporte quant à elle avantageusement un dépôt d'une couche séparatrice d'oxyde sur la première partie de la région d'émetteur et un dépôt de silicium polycristallin sur la couche séparatrice d'oxyde.

Comme indiqué ci-avant, la réalisation d'un émetteur partiellement épitaxié monocristallin "directement sur la base", (par abus de langage car en fait la jonction émetteur-base délimitant la partie supérieure de la base intrinsèque se situe dans la couche supérieure d'encapsulation) se traduit par une absence d'oxyde d'interface proche de la jonction émetteur-base et conduit donc à une réduction notable du bruit basse fréquence. En outre, la présence d'une base à hétérojonction silicium-germanium, contribue également à obtenir un gain en courant acceptable du fait de l'abaissement de la barrière de potentiel. La combinaison d'une base SiGe et d'un émetteur bipartite est donc particulièrement avantageuse du point de vue du gain en courant.

Selon un mode de mise en oeuvre de l'invention, la première sous-étape de réalisation de l'émetteur (partie monocristalline) comprend:
- une première phase comportant le dépôt sur la surface dudit empilement d'une première couche de dioxyde de silicium, le dépôt sur la première couche de dioxyde de silicium d'une deuxième couche de nitrure de silicium, une gravure dans la couche de nitrure de silicium avec arrêt sur la première couche de dioxyde de silicium d'une zone correspondant à l'emplacement de la fenêtre émetteur, puis une désoxydation chimique de ladite zone de façon à obtenir dans ladite fenêtre une surface de silicium ayant une concentration d'atomes d'oxygène inférieure à 10¹⁵/cm², et
- une deuxième phase comportant l'exposition du bloc semi-conducteur obtenu à ladite première phase, à un mélange gazeux de silane et de dopants en atmosphère contrôlée non oxydante, par exemple sous vide, dans un réacteur de dépôt CVD ultrapropre bien connu de l'homme du métier.

Ainsi, l'invention permet d'utiliser des conditions classiques de dépôt de polysilicium dans un réacteur CVD ultrapropre. Cependant, le silicium croît monocristallin sur la base en raison du caractère chimiquement propre de la fenêtre de celle-ci.

Par contre, l'utilisation des conditions classiques de dépôt de polysilicium permet, dans la deuxième sous-étape (partie haute de l'émetteur), en raison de la présence de la couche séparatrice d'oxyde, d'obtenir du silicium polycristallin.

Selon une première variante de l'invention, à l'issue de la deuxième sous-étape on obtient une couche de silicium polycristallin que l'on grave de façon à former un émetteur comportant une région supérieure plus large que la fenêtre émetteur et s'appuyant sur une partie de la couche de nitrure de silicium. On forme alors des espaceurs isolants au contact des parois verticales de la région supérieure plus large de l'émetteur.

Selon une autre variante de l'invention, ladite première phase de la première sous-étape comporte le dépôt sur la deuxième couche de nitrure de silicium, d'une troisième couche épaisse de dioxyde de silicium, et une gravure préliminaire dans la troisième couche de dioxyde de silicium avec arrêt sur la deuxième couche de nitrure de silicium, d'une région correspondant à l'emplacement de ladite zone, et par conséquent de la fenêtre émetteur, de façon à obtenir à l'issue de la première phase, un bloc semiconducteur comportant un empilement des trois couches isolantes délimitant une cavité de même largeur que ladite fenêtre émetteur. A l'issue de la deuxième phase, c'est-à-dire après épitaxie de l'émetteur, et à l'issue de la deuxième sous-étape, on obtient un remplissage de ladite cavité par le silicium monocristallin surmonté de la couche d'oxyde séparatrice surmontée du silicium polycristallin. On grave alors la troisième couche de dioxyde de silicium de part et d'autre du bloc émetteur formé dans la cavité et on forme des espaceurs isolants au contact des parois verticales de l'émetteur.

En d'autres termes, selon cette variante de l'invention, on obtient une distance plus réduite entre le bord de l'émetteur et la zone implantée de base extrinsèque ce qui contribue à diminuer encore la résistance de base ainsi que la capacité base-collecteur. En outre, cette distance réduite est contrôlée par un seul niveau de photolithographie.

L'invention a également pour objet un transistor bipolaire vertical comprenant un collecteur intrinsèque disposé sur une couche de collecteur extrinsèque enterrée dans un substrat semiconducteur, une région d'isolement latéral entourant la partie supérieure du collecteur intrinsèque, un puits de collecteur extrinsèque déporté, une base comprenant une région semiconductrice située au-dessus du collecteur intrinsèque et de la région d'isolement latéral et comportant au moins une couche de silicium. Le transistor comporte également un émetteur bipartite dopé, entouré par la base, comportant une première partie formée de silicium monocristallin et directement en contact avec la surface supérieure de ladite région semiconductrice dans une fenêtre prédéterminée (fenêtre émetteur) de ladite surface supérieure située au-dessus du collecteur intrinsèque. L'émetteur bipartite comporte également une deuxième partie formée de silicium polycristallin, les deux parties de l'émetteur étant séparée par une couche séparatrice d'oxyde située à distance de la jonction émetteur-base du transistor.

Ladite fenêtre de la surface supérieure de la région semiconductrice comporte une concentration d'atomes d'oxygène avantageusement inférieure à 10¹⁵/cm².

Selon un mode de réalisation de l'invention, la hauteur de la première partie de l'émetteur (monocristallin) est comprise entre quelques nanomètres et quelques dizaines de nanomètres.

Dans le cas où la base est une base à hétérojonction silicium-germanium, ladite région semiconductrice est avantageusement formée d'un empilement de couche comportant au moins une couche de silicium et au moins une couche de Si/Ge.

D'autres avantages et caractéristiques de l'invention apparaîtront à l'examen de la description détaillée de modes de mise en oeuvre et de réalisation, nullement limitatifs, et des dessins annexés sur lesquels:
- les figures 1 à 7 illustrent schématiquement un premier mode de mise en oeuvre du procédé selon l'invention aboutissant à un premier mode de réalisation d'un transistor bipolaire selon l'invention, et
- les figures 8 à 13 illustrent schématiquement un deuxième mode de mise en oeuvre du procédé selon l'invention aboutissant à un deuxième mode de réalisation d'un transistor bipolaire selon l'invention.

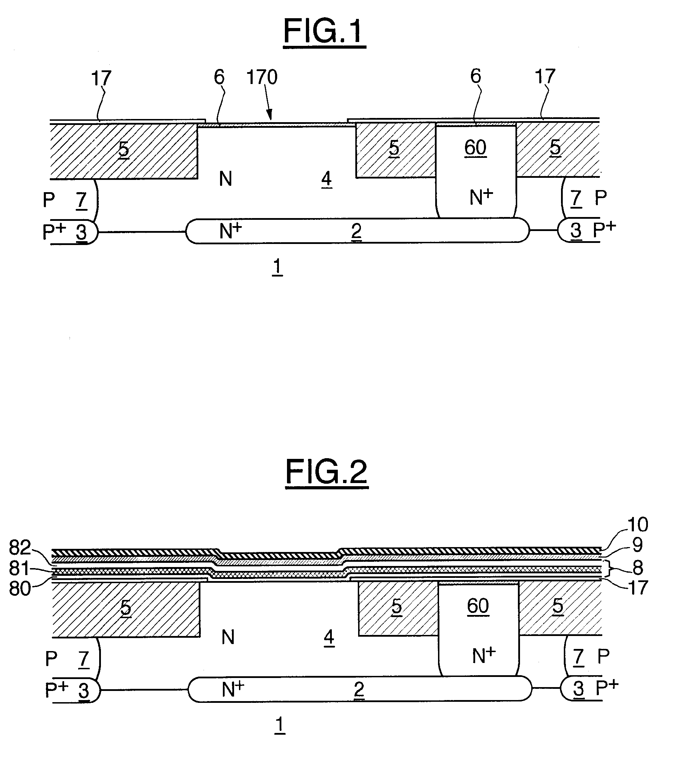

Sur la figure 1, la référence 1 désigne un substrat de silicium, par exemple du type P à la surface duquel on réalise de façon classique et connue en soi une couche enterrée 2 de collecteur extrinsèque, dopée N⁺, par une implantation d'arsenic.

On réalise de même, de façon classique, de part et d'autre du collecteur extrinsèque 2, deux couches enterrées 3, dopées P⁺ à partir d'une implantation de bore.

Sur le substrat 1 ainsi formé, on réalise une épitaxie épaisse, connue en soi, de façon à réaliser une couche 4 de silicium monocristalline de type N ayant une épaisseur typiquement de l'ordre de 1 micron.

On réalise ensuite dans cette couche 4, de façon connue en soi, une région d'isolement latéral 5, soit par un procédé d'oxydation localisée (ou LOCOS), soit du type "tranchée peu profonde" ("Shallow Trench"). On a représenté sur la figure 1, à des fins de simplification, une région d'isolement latéral 5 du type à tranchée peu profonde.

On réalise également de façon classique, notamment par implantation de phosphore, un puits collecteur 60 dopé N⁺ contactant la couche enterrée 2.

On réalise ensuite des implantations de bore de façon à réaliser sous la région d'isolement latéral 5 des caissons 7 dopés P permettant un isolement vis-à-vis des transistors adjacents au transistor bipolaire décrit ici.

On fait croître ensuite, de façon classique, sur la surface du collecteur intrinsèque monocristallin épitaxié 4, un oxyde thermique, typiquement du dioxyde de silicium. Cette croissance de dioxyde de silicium se produit également sur toute la plaquette, et notamment sur le puits collecteur 60. Cet oxyde forme également l'oxyde de grille pour des transistors complémentaires à effet de champ à grilles isolées (transistors CMOS) réalisés conjointement au transistor bipolaire sur la même plaquette (technologie BiCMOS: Bipolaire-CMOS).

On dépose ensuite sur le bloc semiconducteur ainsi formé une couche 17 de silicium amorphe ayant une épaisseur de l'ordre de 500 Å.

On grave ensuite, par gravure plasma avec arrêt sur la couche d'oxyde 6, une fenêtre 170 dite "fenêtre de base". Les deux parties de la couche 17 de silicium gravée peuvent ou non déborder légèrement au-dessus du collecteur intrinsèque 4.

On procède ensuite (figure 2) à une désoxydation chimique de la couche d'oxyde 6 située au-dessus du collecteur. Il convient de noter ici que l'une des fonctions de la couche de silicium amorphe 17 est une fonction de protection du reste de la plaquette lors de cette désoxydation chimique et notamment des zones d'isolement latéral lorsque celles-ci sont réalisées par des tranchées peu profondes.

On procède ensuite, après un traitement de désorption de la fenêtre de base sous hydrogène à une température supérieure à 600°C, à une épitaxie d'un empilement 8 de trois couches 80, 81 et 82, au sein desquelles sera réalisée la future base du transistor. Plus précisément, on procède à une épitaxie d'une première couche 80 de silicium non dopée sur une épaisseur de quelques dizaines de nanomètres. La deuxième couche 81 formée de silicium-germanium est ensuite épitaxiée. Elle est en fait composée d'une première sous-couche de Si₁₋ₓGeₓ avec x constant compris entre 0,1 et 0,2, surmontée d'une deuxième sous-couche formée également d'un alliage de Si₁₋ₓGeₓ (avec x par exemple décroissant jusqu'à 0) et dopée P par du bore. L'épaisseur totale de la couche 81 est peu importante, typiquement de 20 à 100 nm.

La deuxième sous-couche de la couche 81 est ensuite surmontée d'une couche épitaxiée 82 de quelques dizaines de nanomètres d'épaisseur de silicium dopé P à partir de bore.

A l'issue de cette épitaxie, réalisée typiquement à 700°C dans un réacteur de dépôt CVD ultrapropre, on obtient donc un empilement de couches monocristallines sur le collecteur intrinsèque dans la fenêtre de base, et polycristallines au-dessus des couches de silicium amorphe 17. Cet empilement de couches va permettre de former une base à hétérojonction silicium-germanium. Il est à noter ici que l'épitaxie de réalisation de la base à hétérojonction est une épitaxie non sélective.

Par ailleurs, la présence de la couche de silicium amorphe 17 permet de présenter en début d'épitaxie une surface essentiellement formée de silicium ce qui permet d'obtenir une vitesse de croissance sensiblement identique sur le collecteur intrinsèque et sur le silicium amorphe conduisant à l'obtention d'une meilleure homogénéité en épaisseur de la base.

On dépose ensuite sur la couche 82 une première couche de dioxyde de silicium ayant une épaisseur de l'ordre de 200 Å. On dépose également sur la première couche de dioxyde de silicium 9, une deuxième couche 10 de nitrure de silicium (Si₃N₄) ayant une épaisseur de 300 Å.

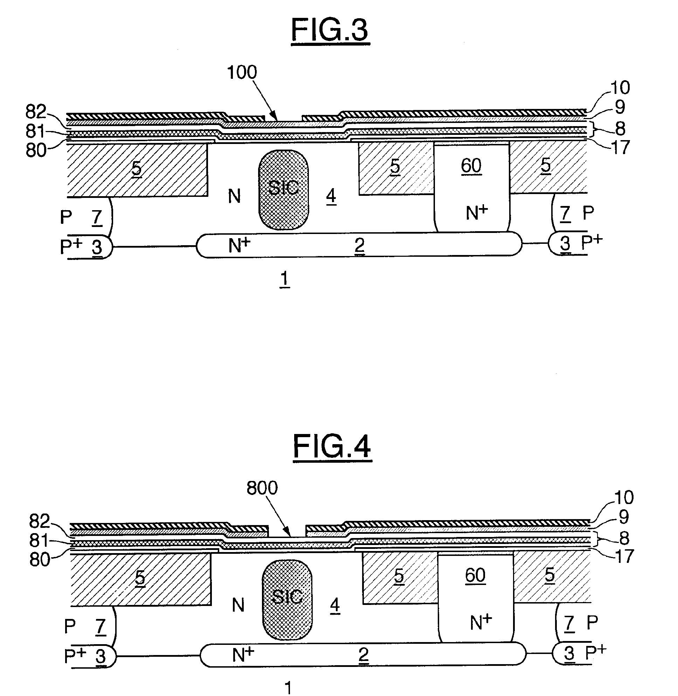

On définit ensuite (figure 3) à l'aide d'un masque une zone 100 dans la couche de nitrure 10 correspondant à une fenêtre émetteur située au-dessus du collecteur intrinsèque 4. On effectue alors de façon classique, à l'aide d'une couche de résine correspondant audit masque, une gravure plasma de la couche de nitrure 10 avec arrêt sur la couche de dioxyde de silicium 9 de façon à dégager la zone 100. On procède ensuite, en conservant la résine présente sur la couche 10 et ayant servi à la gravure de cette dernière, à l'implantation de phosphore, à travers la base. Un surdopage sélectif du collecteur ("selective implantation of collector") sous la fenêtre de l'émetteur peut être réalisé en une ou plusieurs implantations contribuant ainsi à augmenter la rapidité du transistor en diminuant la résistance du collecteur. On obtient donc sous la fenêtre émetteur une zone SIC surdopée.

A l'issue de cette étape, on retire la résine présente sur la couche de nitrure de silicium 10 et l'on procède à un traitement chimique de desoxydation de façon à retirer la partie de la couche de dioxyde de silicium 9 située dans la zone 100 et réaliser ainsi la fenêtre émetteur 800 (figure 4).

Un exemple d'un tel traitement chimique de désoxydation consiste à utiliser un bain d'acide à base d'acide fluorhydrique dilué à environ 1% pendant 1 minute, ce qui permet d'obtenir une surface de silicium monocristallin chimiquement propre, c'est-à-dire dont la concentration d'atomes d'oxygène est inférieure à 10¹⁵/cm². Par ailleurs, une telle désoxydation chimique ne dégrade pas la surface de silicium monocristallin sous-jacente (au contraire d'une gravure plasma par exemple) et par conséquent n'introduit pas de défauts cristallins.

Pour parfaire encore l'état de surface du silicium, on effectue avantageusement un traitement de désorption sous hydrogène à haute température (> à 550°C) de façon à évacuer des impuretés résiduelles adsorbées sur la surface du silicium lors de la désoxydation.

On procède ensuite dans un réacteur de dépôt CVD ultrapropre, par exemple celui commercialisé par la Société Applied Materials sous la référence Centura HTF, à la réalisation de la première partie de l'émetteur du transistor.

Plus précisément, on expose le bloc semiconducteur avec la base découverte au niveau de la fenêtre émetteur 800 à un mélange gazeux de silane et d'arsine, dans une atmosphère non oxydante, typiquement sous vide, ou sous hydrogène.

Les conditions du dépôt CVD sont par exemple un débit de 10 litres d'hydrogène/mn, un débit de 0,5 litres de silane/mn et un débit de 0,12 cm³ d'arsine/mn, à 630°C et sous une pression de 80 Torr.

L'homme du métier aura remarqué que ces conditions correspondent en fait à un dépôt polysilicium. Cependant, en raison du caractère chimiquement propre de la surface monocristalline de la base découverte au niveau de la fenêtre 800, le silicium déposé dans ce réacteur, épitaxie, c'est-à-dire qu'il croît monocristallin sur la base. Par contre, au contact des flancs des couches 9 et 10 et de la surface supérieure de la couche 10, le silicium déposé est polycristallin.

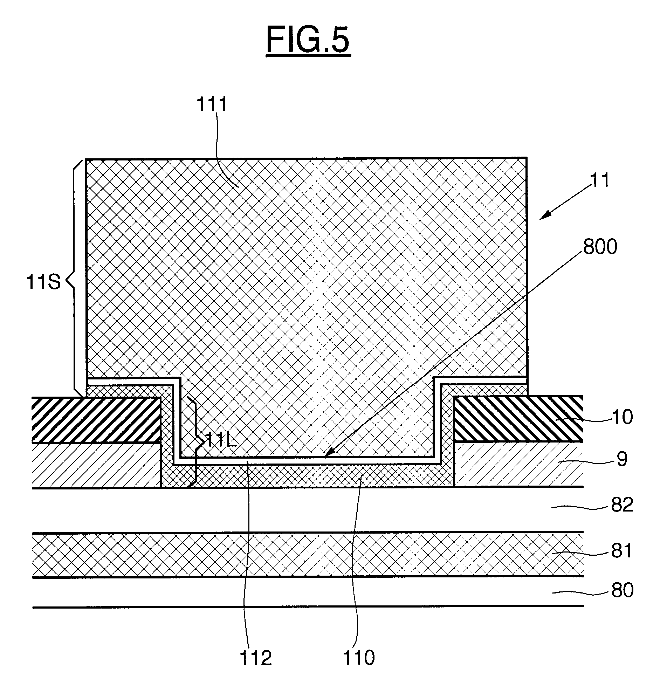

Après avoir obtenu une couche 110 de silicium monocristallin dans la partie en contact avec le silicium de la base et polycristallin le long des flancs des couches 9 et 10 et sur la surface de la couche 10 (figure 5), et ayant une épaisseur comprise entre quelques nanomètres et quelques dizaines de nanomètres, par exemple comprise entre 4 nanomètres environ et 20 nanomètres environ, par exemple 8 nanomètres, on procède de façon classique à la réalisation, typiquement par un nettoyage oxydant de la couche 110, d'une couche séparatrice d'oxyde de silicium 112 ayant typiquement une épaisseur inférieure à un nanomètre. Puis, en conservant les mêmes conditions de dépôt que celles utilisées pour l'obtention de la première partie 110 de l'émetteur, on obtient un dépôt d'une couche de silicium polycristallin 111. Cette couche 111 peut être également déposée de façon clasique dans un four classique de dépôt de polysilicium. Dans ce cas, l'oxyde interfacial 112 se forme naturellement à l'entrée du four.

On procède alors de façon classique en utilisant un nouveau masque de photolithographie ainsi qu'un bloc correspondant de résine, à une gravure de la couche de silicium polycristallin de façon à obtenir (figure 5) un émetteur 11 comportant une première partie 110 formée de silicium monocristallin, surmontée d'une couche séparatrice d'oxyde 112, elle-même surmontée d'une deuxième partie 111 formée de silicium polycristallin. La hauteur totale de l'émetteur est typiquement comprise entre 150 nanomètres et 250 nanomètres.

Cet émetteur, qui a été dopé in situ, est donc monocristallin au voisinage de l'interface avec la base dans la fenêtre émetteur. Il est polycristallin au-dessus de la couche séparatrice d'oxyde. De ce fait, la couche séparatrice d'oxyde se situe à une plus grande distance de la jonction émetteur-base que dans les transistors à émetteur polycristallin classique ce qui permet une diminution du bruit basse fréquence tout en conservant les caractéristiques statiques et dynamiques élevées des transistors à émetteurs polycristallins.

Par ailleurs, dans cette variante de l'invention, la partie supérieure 11S de l'émetteur est plus large que la partie inférieure 11L de l'émetteur située dans la fenêtre émetteur. Typiquement, la distance entre le bord de la fenêtre émetteur et le bord de la région supérieure 11S est typiquement de l'ordre de 0,2µm.

On procède ensuite à un dépôt d'une couche de nitrure de silicium que l'on grave de façon à obtenir des espaceurs 120 incluant la couche 10 de nitrure de silicium, s'appuyant sur les parois verticales de la région supérieure de l'émetteur et sur la couche de dioxyde de silicium 9.

On dépose ensuite une vignette de résine au-dessus de l'émetteur, puis on procède à une implantation P⁺ de l'empilement 8 à l'aide de bore, de façon à définir la base extrinsèque Be.

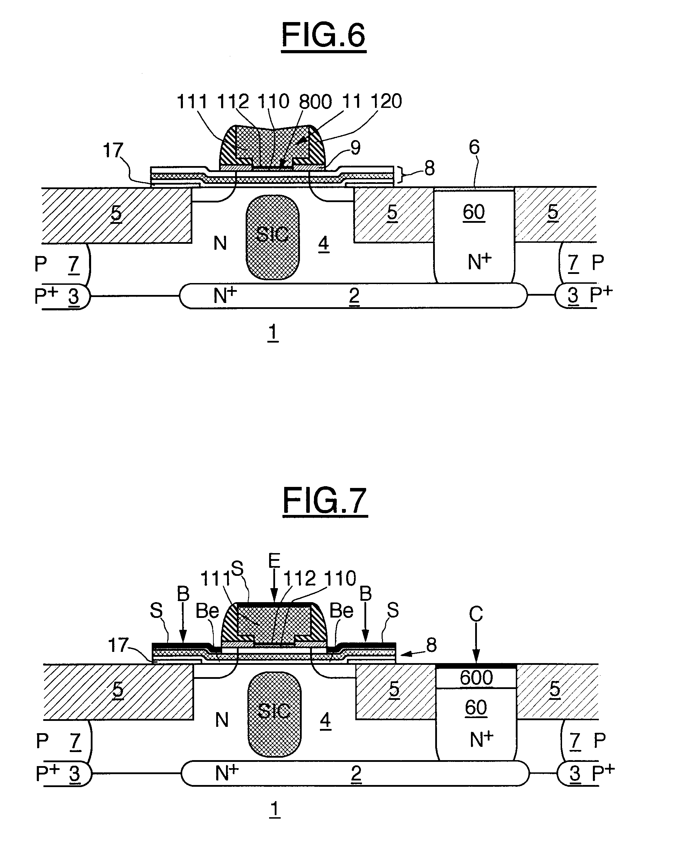

On définit ensuite à l'aide d'un nouveau masque, la géométrie de la base du transistor et l'on procède, après avoir préalablement gravé la couche d'oxyde 9, à une gravure de l'empilement des couches 17 et 8 de façon à obtenir la configuration illustrée sur la figure 6.

On procède ensuite, après avoir protégé le transistor par de la résine, à une implantation d'arsenic, de façon à réaliser à la surface du puits collecteur une zone implantée N⁺ référencée 600.

L'étape finale consiste à réaliser les prises des connexions S de base d'émetteur et de collecteur par une technique connue du type "siliciure autoaligné" ("self aligned silicide") qui comporte le dépôt d'une couche de métal (par exemple du titane) pour former un siliciure (TiSi₂) sur les zones de silicium de la base extrinsèque, de l'émetteur et du collecteur extrinsèque.

Le transistor selon l'invention, tel qu'illustré sur la figure 7, est donc un transistor bipolaire vertical n-p-n à base à hétérojonction silicium-germanium utilisable dans une technologie BiCMOS du type VLSI. Il comporte un émetteur ayant une première partie formée de silicium monocristallin directement en contact avec le silicium de la couche supérieure d'encapsulation (82). Cependant, en raison notamment des diffusions de dopants et de divers traitement thermiques classiques, la jonction émetteur/base se situe à l'intérieur de la couche 82. La couche d'oxyde séparatrice 112 se situe à distance de la jonction émetteur-base. Le transistor présente un bruit basse fréquence réduit, tout en conservant de bons paramètres statiques, notamment le gain en courant. Il présente en outre une résistance d'émetteur réduite par rapport à des transistors à émetteur polycristallin classique. Il convient de noter qu'à des fins de simplification des dessins, seules les parties rectilignes basses des couches 110 et 112 ont été représentées sur les figures 6 et 7.

Dans la variante de réalisation qui vient d'être décrite, la distance entre le bord de la fenêtre 800 et le bord de la région supérieure 11S de l'émetteur dépend de l'alignement du masque de photolithographie utilisé pour la gravure de la région supérieure de l'émetteur par rapport au masque de photolithographie utilisé pour la gravure de la fenêtre émetteur proprement dite. Ceci rend un peu plus délicate la fabrication du transistor.

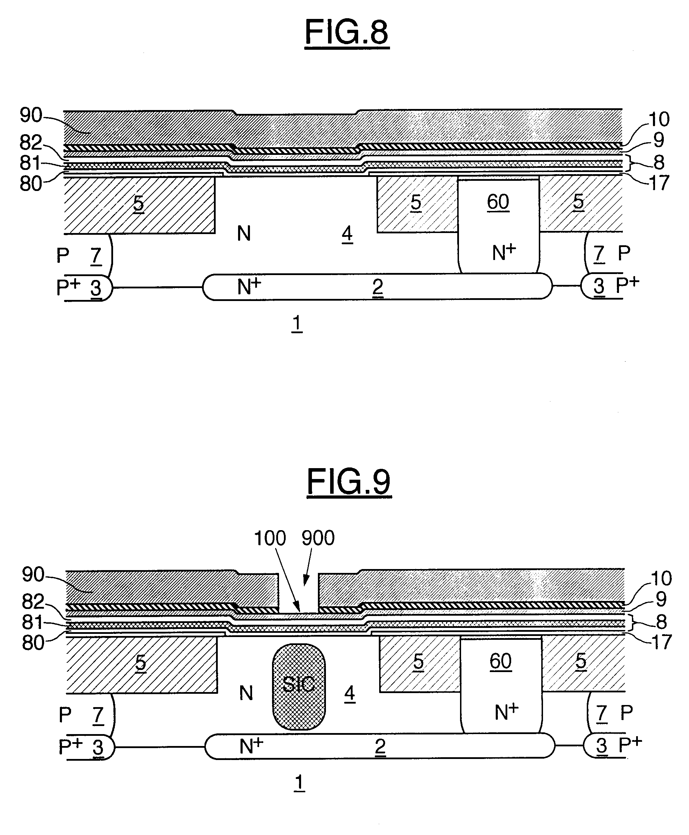

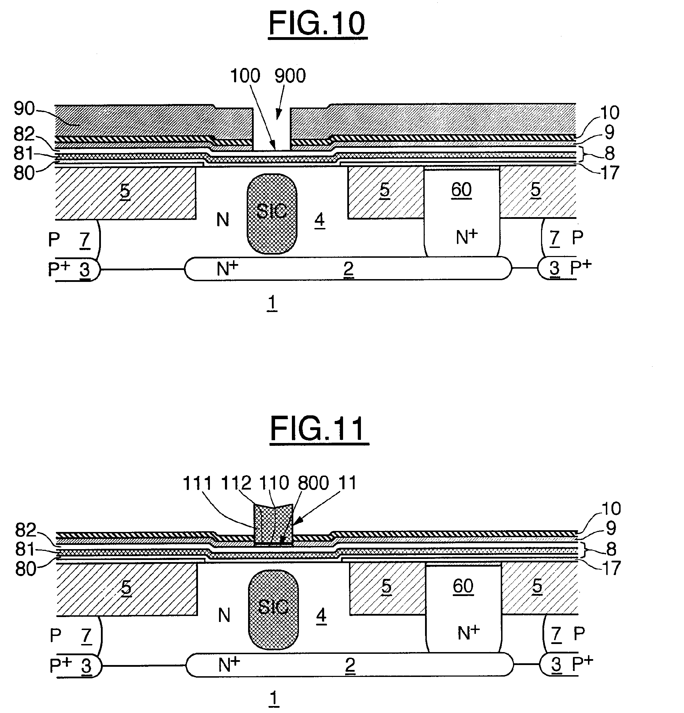

La variante de réalisation illustrée sur les figures 8 à 13 permet de s'affranchir de ce problème. En effet, comme illustré sur la figure 8, on dépose sur la couche 10 de nitrure de silicium une troisième couche épaisse de dioxyde de silicium 90 (ayant typiquement une épaisseur de 2000Å). On procède ensuite (figure 9) à une gravure plasma classique de la couche épaisse 90 avec arrêt sur la deuxième couche 10 de nitrure de silicium, d'une région 900 correspondant à l'emplacement de la zone 100 de la couche 10 (figure 3) et par conséquent à l'emplacement de la fenêtre émetteur 800. On poursuit la gravure de la fenêtre émetteur (figure 10) d'une façon analogue à celle qui a été décrite dans le mode de mise en oeuvre précédent. De même, l'implantation de la zone SIC est analogue à celle qui était décrite ci-avant.

On procède ensuite d'une façon analogue à celle qui a été décrite ci-avant, au dépôt de silicium dans des conditions de dépôt polysilicium provoquant la ré-épitaxie du silicium 110 sur la base dans la cavité ménagée au sein de l'empilement des couches successives de dioxyde de silicium 9, de nitrure de silicium 10 et de dioxyde de silicium 90. Ce dépôt de silicium monocristallin est suivi, d'une façon analogue à ce qui était décrit ci-avant par une formation de la couche séparatrice d'oxyde 112 suivi d'un dépôt de silicium polycristallin.

On supprime ensuite, par exemple par un polissage mécanochimique, ou bien par une gravure pleine plaque avec arrêt sur la couche d'oxyde 90, le silicium polycristallin débordant en dehors de la cavité puis on procède (figure 11) à une gravure plasma de la couche 90 de part et d'autre du silicium polycristallin 111, avec arrêt sur la couche de nitrure de silicium 10, de façon à obtenir un émetteur formé d'un seul bloc ayant la même largeur que la fenêtre émetteur. Là encore, à des fins de simplification des dessins, seules les parties rectilignes basses des couches 110 et 112 ont été représentées sur les figures 11 et suivantes.

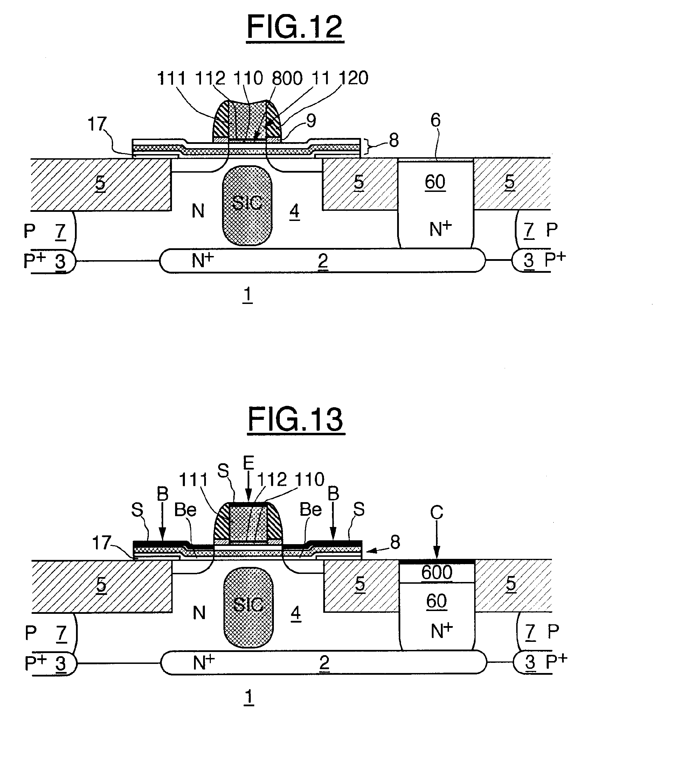

Les étapes suivantes de cette mise en oeuvre, et notamment la formation des espaceurs 120, sont analogues à celles qui ont été décrites ci-avant (figures 12 et 13).

On obtient de ce fait une distance réduite entre le bord de l'émetteur et le bord des espaceurs 120, distance qui n'est plus contrôlée par une opération de photolithographie.

Outre la simplification technologique, on obtient une résistance de base plus faible et une capacité base collecteur plus faible pour le transistor illustré sur la figure 13.

## Revendications

1. Procédé de fabrication d'un transistor bipolaire vertical, caractérisé par le fait qu'il comprend une étape de réalisation d'un collecteur intrinsèque (4) sur une couche de collecteur extrinsèque (2) enterrée dans un substrat semiconducteur (1), une étape de réalisation d'une région d'isolement latéral (5) entourant la partie supérieure du collecteur intrinsèque et d'un puits de collecteur extrinsèque déporté (60), une étape de réalisation d'une base (8) située au-dessus du collecteur intrinsèque et de la région d'isolement latéral et comportant une épitaxie non sélective d'une région semiconductrice (8) comportant au moins une couche de silicium, et une étape de réalisation d'un émetteur bipartite dopé in situ (11) comportant une première sous-étape de réalisation d'une première partie (110) de l'émetteur formée de silicium monocristallin et directement en contact avec une partie (800) de la surface supérieure de ladite région semiconductrice située au-dessus du collecteur intrinsèque et une deuxième sous-étape de réalisation d'une deuxième partie (111) de l'émetteur formée de silicium polycristallin, les deux parties (110, 111) étant séparées par une couche séparatrice d'oxyde (112).

2. Procédé selon la revendication 1, caractérisé par le fait que l'étape de réalisation de la base comporte une épitaxie non sélective d'un empilement (8) de couches formant ladite région semiconductrice et comportant outre ladite couche de silicium, au moins une couche de SiGe (81), par le fait que la première sous-étape de réalisation de l'émetteur comporte une épitaxie sur une fenêtre prédéterminée (800) de la surface dudit empilement situé au-dessus du collecteur intrinsèque de façon à obtenir au-dessus de ladite fenêtre ladite première partie (110) de la région d'émetteur formée de silicium monocristallin et directement en contact avec la couche supérieure (82) dudit empilement (8), et par le fait que la deuxième sous-étape comporte la formation de la couche séparatrice d'oxyde (112) sur la première partie de la région d'émetteur et un dépôt de silicium polycristallin sur ladite couche séparatrice d'oxyde.

3. Procédé selon la revendication 2, caractérisé par le fait que la première sous-étape de réalisation de l'émetteur comprend
une première phase comportant le dépot sur la surface dudit empilement (8) d'une première couche de dioxyde de silicium (9), le dépôt sur la première couche de dioxyde de silicium (9) d'une deuxième couche de nitrure de silicium (10), une gravure dans la couche de nitrure de silicium (10) avec arrêt sur la première couche de dioxyde de silicium (9) d'une zone (100) correspondant à l'emplacement de ladite fenêtre (80), une désoxydation chimique de ladite zone (100) de façon à obtenir dans ladite fenêtre (80) une surface de silicium ayant une concentration d'atomes d'oxygène inférieure à 10¹⁵ par cm², et
une deuxième phase comportant l'exposition du bloc semiconducteur obtenu à ladite première phase, à un mélange gazeux de silane et de dopants en atmosphère contrôlée non oxydante.

4. Procédé selon la revendication 3, caractérisé par le fait qu'à l'issue de la deuxième sous-étape on obtient une couche de silicium polycristallin que l'on grave de façon à former un émetteur (11) comportant une région supérieure (11S) plus large que la fenêtre (800) et s'appuyant sur une partie de la couche de nitrure de silicium (10), et par le fait qu'on forme des espaceurs isolants (120) au contact des parois verticales de la région supérieure plus large de l'émetteur.

5. Procédé selon la revendication 3, caractérisé par le fait que ladite première sous-étape comporte le dépôt sur la deuxième couche de nitrure de silicium (10) d'une troisième couche épaisse de dioxyde de silicium (90), et une gravure préliminaire dans la troisième couche de dioxyde de silicium (90) avec arrêt sur la deuxième couche de nitrure de silicium (10) d'une région (900) correspondant à l'emplacement de ladite zone (100), de façon à obtenir à l'issue de la première phase de la première sous-étape un bloc semi-conducteur comportant dans l'empilement des trois couches isolantes une cavité de même largeur que ladite fenêtre (80), par le fait qu'à l'issue de la deuxième phase de la première sous-étape et à l'issue de la deuxième sous-étape on obtient un remplissage de ladite cavité par le silicium monocristallin (110) surmonté de la couche d'oxyde séparatrice (112) surmontée du silicium polycristallin (111), par le fait qu'on grave la troisième couche de dioxyde de silicium (90) de part et d'autre du bloc émetteur (110) formé dans la cavité et on forme des espaceurs isolants au contacts des parois verticales de l'émetteur.

6. Transistor bipolaire vertical, caractérisé par le fait qu'il comprend un collecteur intrinsèque (4) disposé sur une couche de collecteur extrinsèque (2) enterrée dans un substrat semiconducteur, une région d'isolement latéral (5) entourant la partie supérieure du collecteur intrinsèque, un puits de collecteur extrinsèque déporté (60), une base (8) comprenant une région semiconductrice située au-dessus du collecteur intrinsèque et de la région d'isolement latéral et comportant au moins une couche de silicium, et un émetteur bipartite dopé (11), entouré par la base, comportant une première partie (110) formée de silicium monocristallin et directement en contact avec la surface supérieure de ladite région semiconductrice dans une fenêtre prédéterminée (800) de ladite surface supérieure située au-dessus du collecteur intrinsèque, et une deuxième partie (111) formée de silicium polycristallin les deux parties de l'émetteur étant séparées par une couche séparatrice d'oxyde (112) située à distance de la jonction émetteur-base du transistor.

7. Transistor selon la revendication 6, caractérisé par le fait que la fenêtre (800) de la surface supérieure de la région semiconductrice (8) comporte une concentration d'atomes d'oxygène inférieure à 10¹⁵ / cm².

8. Transistor-selon la revendication 6 ou 7, caractérisé par le fait que la hauteur de la première partie(l10) de l'émetteur est comprise entre quelques nanomètres et quelques dizaines de nanomètres.

9. Transistor selon l'une des revendications 6 à 8, caractérisé par le fait que ladite région semiconductrice (8) est formée d'un empilement de couches comportant au moins une couche de silicium et au moins une couche de SiGe.
